# EUROPÄISCHE PATENTSCHRIFT

(11) **EP 0 558 547 B1**
(45) Veröffentlichungstag und Bekanntmachung des Hinweises auf die Patenterteilung: **20.09.1995**
(21) Anmeldenummer: 91919980.2
(22) Anmeldetag: 11.11.1991
(51) Int. Cl.: H05K 1/03

(54) **VERFAHREN ZUR HERSTELLUNG VON KUPFERKASCHIERTEN BASISMATERIALTAFELN**
PROCESS FOR THE PRODUCTION OF COPPER-COATED SUBSTRATES
PROCEDE POUR LA FABRICATION DE SUBSTRATS COUVERTS D'UNE COUCHE DE CUIVRE

(30) Priorität: 19.11.1990 DE 4036802
(43) Veröffentlichungstag der Anmeldung: 08.09.1993
(73) Patentinhaber: HT TROPLAST AG, D-53839 Troisdorf (DE)
(72) Erfinder: FASBENDER, Helmut, D-5060 Bergisch-Gladbach (DE); VOSS, Burkhard, D-5024 Pulheim (DE)
(86) Internationale Anmeldenummer: EP9102130
(87) Internationale Veröffentlichungsnummer: WO9209186

(56) Entgegenhaltungen:
- EP-A- 0 272 563
- WO-A-88/01938
- GB-A- 2 093 035

## Beschreibung

### Verfahren zur Herstellung von kupferkaschierten Basismaterialtafeln

### Technisches Gebiet

Die Erfindung betrifft ein Verfahren zur Herstellung von kupferkaschierten Basismaterialtafeln sowie ein Verfahren zur Herstellung von Multilayern aus diesen Basismaterialtafeln.

Basismaterialtafeln (Circuit Boards) sind ein- oder beidseitig kupferkaschierte Tafeln aus im allgemeinen faserverstärkten, duroplastischen Harzen, wobei sich das Harz im C-Zustand befindet. Sie dienen zur Herstellung von Leiterplatten für die Elektronik-Industrie sowie ggf. zur Weiterverarbeitung zu Multilayern.

Multilayer sind Schichtstoffe aus einer Mehrzahl von Basismaterialtafeln. Zur Herstellung werden die mit entsprechenden Leiterbahnen versehenen Basismaterialtafeln (Harz im C-Zustand) mit zwischengelegten (Klebe-) Prepregs (Harz im B-Zustand) unter Anwendung von Druck und Wärme verpreßt, wobei das Harz der Prepregs in den C-Zustand aushärtet.

Prepregs sind mit Harz imprägnierte Substrate, im allgemeinen Glasfasergewebebahnen, wobei sich das Harz im noch nicht vollständig ausgehärteten (B-) Zustand befindet.

Ein übliches Verfahren zur Herstellung von kupferkaschierten Basismaterialtafeln ist das Verpressen von mehreren Lagen von Prepreg-Zuschnitten mit Decklagen aus Kupferfolie unter Anwendung von Druck und Wärme, wobei das Harz der Prepregs in den C-Zustand ausgehärtet wird.

### Stand der Technik

Aus der WO 88/01 938 ist ein gattungsgemäßes Verfahren zur Herstellung von ein- oder beidseitig kupferkaschierten Basismaterialtafeln nach der sogenannten Fadenwickeltechnik sowie deren Anwendung zur Herstellung von Multilayern bekannt. Bei diesem Verfahren wird als Wickeldorn ein mit einer Kupferfolie belegtes Stahlblech verwendet. Dieses wird mit Garnfäden eines Verstärkungsmaterials, vorzugsweise E-Glas, zunächst über die Breite in möglichst geringer Neigung einlagig umwickelt, wobei der Wickeldorn rotiert. Dieser Wickelvorgang wird nach der ganzflächigen Bewicklung des Bleches unter einem Winkel von 90° wiederholt, wodurch eine zweite Lage aufgebracht wird. Der Vorgang des kreuzweisen Wickelns wird so oft wiederholt, bis der gewünschte Glasanteil bzw. die gewünschte Dicke der Wickellagen erreicht ist. Anstelle der üblichen Gewebeverstärkung entsteht so ein Gelege, in dem die Einzelfäden nicht miteinander verwoben sind, sondern lose aufeinander liegen.

Nach Abschluß des Wickelvorgangs wird mit Hilfe zweier auf der Innenseite mit Kupferfolie belegter Bleche sowie seitlicher Abdichtungsstege eine geschlossene Form hergestellt, die auf einen Restdruck kleiner 2 mm Hg evakuiert wird. Danach läßt man in einem Injektions- bzw. Gießverfahren, das z.B. als RTM-Verfahren (Resin Transfer Molding) dem Fachmann bekannt ist, eine vorbereitete und ggf. angewärmte Harzmischung einströmen und nach Beendigung des Befüllvorganges bei erhöhter Temperatur aushärten.

Das in der WO 88/01 938 beschriebene Gießharzgemisch aus Epoxidharz und Anhydridhärter weist jedoch eine schlechte Kupfer- und Lagenhaftung auf, da ein Härter in recht großen Gewichtsmengen zugesetzt werden muß, der die Klebkraft beeinträchtigt.

Insbesondere bei Basismaterialtafeln mit dünner Kupferfolie, z.B. 17,5 µm Dicke, deren Anwendung für Fein- und Feinstleitertechnik unerläßlich ist, fällt die Abschälkraft bis auf 1,0 N/mm und darunter ab, so daß die erforderlichen Werte nicht erreicht werden.

### Aufgabe

Aufgabe der Erfindung ist es daher, ein gattungsgemäßes Verfahren zur Herstellung von Basismaterialtafeln zur Verfügung zu stellen, das zu Tafeln mit höheren Abschälkräften der Kupferfolie und besserer Lagenbindung führt.

Ein weiteres Anliegen der Erfindung ist es, ein verbessertes Verfahren zur Herstellung von Multilayern unter Verwendung von nach dem Fadenwickelverfahren (WO 88/01 938) hergestellten Basismaterialtafeln zur Verfügung zu stellen.

### Darstellung der Erfindung

Erfindungsgemäß wird ein Verfahren mit den Merkmalen des Anspruches 1 vorgeschlagen, bei welchem als Harz zur Herstellung wenigstens einseitig kupferkaschierter Basismaterialtafeln ein lösungsmittelfreies Epoxiisocyanuratharz mit einer Viskosität bei Verarbeitungstemperatur von weniger als 1000 mPa.s nach DIN 53015, bevorzugt weniger als 500 mPa.s, und einem NCO-Gehalt größer 20 % verwendet wird.

Überraschend hat sich herausgestellt, daß durch das erfindungsgemäße Verfahren sehr hohe Kupferhaftkräfte - typisch zwischen 1,6 und 1,8 N/mm - erzielt werden. Die Haftung des Kupfers ist dabei in gewissem Grad abhängig vom NCO-Gehalt des Harzes, wobei höhere NCO-Gehalte zu besserer Kupferhaftung führen.

Das Epoxiisocyanuratharz wird bevorzugt aus Diphenylmethan-diisocyanat, einem Epoxidharz auf Basis Bisphenol A (Diglycidylether von Bisphenol A, Epoxidzahl 0,585) und einem geeigneten Katalysator, z.B. Dimethylbenzylamin, hergestellt (EP-A2-0 272 563).

Nach einer ersten Ausführung der Erfindung werden die genannten Komponenten nach dem Vermischen unmittelbar zum Imprägnieren bzw. Tränken der Fasergelege entsprechend der WO 88/01 838 verwendet. Das Harz wird dann in der vorteilhaft evakuierten Form bei einer Temperatur von 100 °C bis 150 °C ausgehärtet (bis zum C-Zustand).

Vorteilhaft wird jedoch ein wenigstens teilweise (an-)reagiertes Harzsystem aus den obengenannten Komponenten verwendet, daß durch Zugabe einer Stopperlösung entsprechend der EP-A2-0272563 auf eine entsprechende Viskosität und NCO-Gehalt eingestellt werden kann. Vor dem Imprägnieren bzw. Trocknen des Fasergeleges muß dem Harz ein entsprechender Katalysator, beispielsweise wie in der EP-A2-0 272 563 beschrieben, zugegeben werden.

Das erfindungsgemäße Verfahren zur Herstellung von Multilayern besitzt die Merkmale des Anspruches 3.

Zur Herstellung der für die Multilayer benötigten (Klebe-) Prepregs wird ebenfalls ein Epoxiisocyanuratharz verwendet, jedoch mit einer höheren Viskosität und mit geringerem NCO-Gehalt. Das hierzu verwendete Harz ist bereits relativ weitgehend ausreagiert und damit bei Raumtemperatur fest. Der NCO-Gehalt beträgt weniger als 17 %, bevorzugt weniger als 14 %. Die Tränkung der Prepregsubstrate, bevorzugt handelsübliche Glasgewebebahnen aus E-Glas, erfolgt entweder mit einer Lösung des Harzes oder durch Tränken, bevorzugt in Vakuum, eines durch Erwärmen verflüssigten Harzes. Die Lösung bzw. das erwärmte Harz enthält dabei einen latenten Katalysator, der bei späterer Erwärmung des Prepregs die weitere Reaktion des Harzes in den C-Zustand startet.

Als Harze können die Epoxiisocyanuratharze bzw. -lösungen entsprechend der EP-A2-0 272 563, z.B. nach Beispiel 2 oder Beispiel 3, verwendet werden. Der Harzgehalt der Prepregs beträgt bevorzugt 35-65 Gew.-%, insbesondere 40-50 Gew.-%.

Zur Herstellung der Multilayer werden in an sich bekannter Weise zunächst aus den kupferkaschierten Basismaterialtafeln gedruckte Schaltungen geätzt. Diese werden, jeweils durch ein Klebe-Prepreg getrennt, aufeinander gelegt und in an sich bekannter Weise unter Anwendung von Druck und Wärme zu den Multilayern verpreßt, wobei das Harz der Prepregs in den C-Zustand aushärtet.

Ein besonderer Vorteil des erfindungsgemäßen Verfahrens ist es, daß sowohl für die Herstellung der Basismaterialtafeln als auch der Klebeprepregs ein gleichartiges Harz verwendet werden kann, obwohl das Harz für die Basismaterialtafeln direkt in den C-Zustand ausgehärtet werden muß, während das Harz für die Prepregs lagerstabil im B-Zustand gehalten werden muß. Ggf. können als Prepregs jedoch auch handelsübliche Prepregs auf Epoxidharzbasis verwendet werden.

### Bester Weg zur Ausführung der Erfindung

In einem Ausführungsbeispiel zur Herstellung von Multilayern wird ein lösungsmittelfreies Polyisocyanurat-Reaktionsharz auf der Basis von Diphenylmethandiisocyanat und einem Epoxidharz auf Basis Bisphenol A mit einer Viskosität von 300 mPa.s bei 25 °C sowie mit einem NCO-Gehalt von 25 % (Gemisch aus je 50 Gewichtsteilen der Versuchsprodukte Blendur ^{R} I KU 3-4516 und Blendur ^{R} I KU 3-4520 der Firma Bayer AG) hergestellt und mit 2 Gewichtsteilen eines Anlagerungsproduktes aus Bortrichlorid und Dimethyloctylamin (Fa. Ciba Geigy) katalysiert. Das Gemisch wird in eine auf 50 °C vorgewärmte Form, die mit 4 Lagen Glasgarn ES 9-680 dtex kreuzweise, wie in der WO 88/01 838 beschrieben, auf einen Blechkern bewickelt und auf den Innenflächen mit 35 /um dicker Elektrolytkupferfolie belegt ist, eingeleitet. Nach 2-stündiger Härtung bei 200°C wird die Tafel entformt. Die gemessenen Eigenschaftswerte entsprechen den Sollwerten nach DIN/IEC-249 für Epoxidglashartgewebe Typ FR-4, wobei für die Kupferhaftkraft Werte zwischen 1,6 und 1,8 N/mm gemessen wurden.

Weiterhin wurden bestimmt: die Glasübergangstemperatur Tg mit 280 °C; die Dimensionsstabilität in beiden Raumrichtungen mit je 100 - 110 ppm und die Brennbarkeitsstufe nach UL-94 mit V1.

Zur Herstellung der Klebeprepregs wird ein bei Raumtemperatur festes (Tg=40°C) Polyisocyanuratharz auf der Basis von Diphenylmethandiisocyanat und einem Epoxidharz auf Basis Bisphenol A mit einem NCO-Gehalt von 13 % (Handelsprodukt Blendur I KU 3-4521, Fa. Bayer AG) in Methylethylketon als Lösungsmittel gelöst. Der Lösung wird 2 % eines Anlagerungsproduktes aus Bortrichlorid und Dimethyloctylamin (Fa. Ciba Geigy) als latenter Katalysator zugegeben. Ein Glasgewebe (US-Style 7628) wird anschließend mit der 62 %igen Lösung in einer senkrechten Imprägniermaschine bei einer maximalen Trockenschachttemperatur von 150 °C so imprägniert, daß ein Harzgehalt von 45 Gew.-% erreicht wird. Das so erhaltene Prepreg, dessen Harz einen Restgehalt an NCO-Gruppen von 13 Gew.-% aufweist, wird luft- und feuchtigkeitsdicht in PE-Folie eingeschweißt und ist damit lagerfähig.

Aus der im ersten Verfahrensschritt gewonnenen Tafel wird im üblichen Druckätzverfahren eine zweiseitige Schaltung hergestellt, diese dem ebenfalls üblichen Schwarzoxidierungsverfahren mit handelsüblichen Oxidizern unterworfen, sodann auf beiden Seiten mit je 2 Bogen des im zweiten Verfahrensschritt gewonnenen Prepregs sowie je 1 Bogen 35 µm dicker Elektrolytkupferfolie umlegt und schließlich in einer Presse zwischen 2 Stahlblechen und üblichen Preßpolstern bei 180 °C während 2 Stunden laminiert. Nach Temperung der fertigen Tafel während 2 h bei 200 °C wird sie in üblicher Weise zu einem 4-Ebenen Multilayer weiter verarbeitet.

## Patentansprüche

1. Verfahren zur Herstellung wenigstens einseitig kupferkaschierter Basismaterialtafeln, bei dem
- ein mit einer Kupferfolie belegter Wickelkern mit einer Verstärkungsfaser umwickelt,
- das Fasergelege mit einem lösungsmittelfreien Harz getränkt und
- das Harz in den C-Zustand ausgehärtet wird,
- wobei als Harz ein lösungsmittelfreies Epoxiisocyanuratharz mit einer Viskosität bei Verarbeitungstemperatur von weniger als 1000 mPa.s nach DIN 53015 und einem NCO-Gehalt größer 20 % verwendet wird.

2. Verfahren nach Anspruch 1, ***dadurch gekennzeichnet,*** daß als Harz ein Epoxiisocyanuratharz auf Basis von Diphenylmethandiisocyanat und einem Epoxidharz auf der Basis von Bisphenol A sowie einem Katalysator verwendet wird.

3. Verfahren zur Herstellung von Multilayern, bei dem eine Mehrzahl von Basismaterialtafeln mittels zwischengelegter Prepregs unter Anwendung von Druck und Wärme verpreßt wird, wobei zur Herstellung der Basismaterialtafeln ein mit einer Kupferfolie belegter Wickelkern mit einer Verstärkungsfaser umwickelt, das Fasergelege mit einem lösungsmittelfreien Epoxiisocyanuratharz mit einer Viskosität bei Verarbeitungstemperatur von weniger als 1000 mPa.s nach DIN 53015 und einem NCO-Gehalt von 20 % getränkt und das Harz in den C-Zustand gehärtet wird und wobei als Harz für die Prepregs ein bei Raumtemperatur festes Epoxiisocyanuratharz im A- bzw. B-Zustand und einem NCO-Gehalt kleiner 17 % verwendet wird.

## Claims

1. Process for producing base materials copper-clad on at least one side, in which
- a winding core carrying a copper foil is wound with a reinforcing fibre,
- the laid fibres are impregnated with a solvent-free resin and
- the resin is cured fully to reach the C-stage,
- the resin used is a solvent-free epoxy-isocyanurate resin having a viscosity at processing temperature of less than 1000 mPa.s according to DIN 53015 and a NCO content of more than 20%.

2. Process according to Claim 1, characterised in that the resin used is an epoxy-isocyanurate resin based on diphenylmethane diisocyanate and on a bisphenol A-based epoxide resin as well as a catalyst.

3. Process for producing multilayers, in which a plurality of base materials are pressed with interposed prepregs with application of pressure and heat, in which for producing the base materials a winding core carrying a copper foil is wound with a reinforcing fibre, the laid fibres are impregnated with a solvent-free epoxy-isocyanurate resin having a viscosity at processing temperature of less than 1000 mPa.s according to DIN 53015 and a NCO content of more than 20%, the resin is cured fully to reach the C-stage, and the resin for the prepregs being an epoxy-isocyanurate resin in the A- or B-stage, which is solid at room temperature and has an NCO content of less than 17%.

## Revendications

1. Procédé de fabrication de plaques de matériau substrat portant un revêtement de cuivre sur au moins l'une de leurs faces, dans lequel procédé :
- on enroule des fibres de renfort sur un noyau d'enroulement muni d'une feuille de cuivre,
- on imprègne la couche de fibres d'une résine sans solvant, et
- on fait durcir parfaitement la résine à l'état C,
la résine utilisée étant une résine de type époxyde-isocyanurate sans solvant, dont la viscosité à la température de travail, mesurée selon la norme DIN 53015, vaut moins de 1000 mPa.s et dont la teneur en groupes NCO vaut plus de 20 %.

2. Procédé conforme à la revendication 1, caractérisé en ce que la résine utilisée est une résine de type époxyde-isocyanurate, à base de diphénylméthane-diisocyanate et d'une résine époxyde à base de bisphénol A, ainsi que d'un catalyseur.

3. Procédé de fabrication de stratifiés, dans lequel on comprime ensemble, sous pression et à chaud, plusieurs plaques de matériau substrat entre lesquelles sont disposées des couches de pré-imprégné, les plaques de matériau substrat étant fabriquées par enroulement de fibres de renfort sur un noyau d'enroulement muni d'une feuille de cuivre, par imprégnation de la couche de fibres d'une résine de type époxyde-isocyanurate sans solvant, dont la viscosité à la température de travail, mesurée selon la norme DIN 53015, vaut moins de 1000 mPa.s et dont la teneur en groupes NCO vaut plus de 20 %, et par durcissement de la résine à l'état C, et la résine utilisée pour le pré-imprégné étant une résine de type époxyde-isocyanurate à l'état A ou B, qui est solide à la température ambiante et dont la teneur en groupes NCO vaut moins de 17%.
